Europäisches Patentamt

European Patent Office

Office européen des brevets

(19)

(11) EP 0 623 968 B1

(12) **EUROPÄISCHE PATENTSCHRIFT**

(45) Veröffentlichungstag und Bekanntmachung des Hinweises auf die Patenterteilung:
**01.10.1997 Patentblatt 1997/40**

(51) Int Cl.6: **G08C 19/00**

(21) Anmeldenummer: **94105210.2**

(22) Anmeldetag: **02.04.1994**

(54) **Signalverteilungsanordnung**

Signal distribution device

Dispositif de distribution de signaux

(84) Benannte Vertragsstaaten:
**DE FR GB IT SE**

(30) Priorität: **08.04.1993 DE 4311601**

(43) Veröffentlichungstag der Anmeldung:
**09.11.1994 Patentblatt 1994/45**

(73) Patentinhaber: **DORNIER GmbH**
**D-88039 Friedrichshafen (DE)**

(72) Erfinder:
• **Zahn, Rolf, Dr. Ing.**
**D-88677 Markdorf (DE)**
• **Völker, Michael, Dipl.-Phys.**
**D-88677 Markdorf (DE)**

(74) Vertreter: **Landsmann, Ralf, Dipl.-Ing.**
**Dornier GmbH**
**LHG**
**88039 Friedrichshafen (DE)**

(56) Entgegenhaltungen:
EP-A- 0 109 695          DE-A- 3 928 973
US-A- 4 478 488          US-A- 4 583 096
US-A- 4 885 589

• **IEEE PHOTONICS TECHNOLOGY LETTERS, Bd.5, Nr.11, November 1993, NEW YORK, US Seiten 1347 - 1349 R. D. ESMAN ET AL 'Fiber-optic prism true time-delay antenna feed'**
• **IEE PROCEEDINGS PART J, Bd.139, Nr.4, August 1992, STEVENAGE, HERTS, GB Seiten 305 - 308 M. VÖLKER 'Coherent all-fibre optical beam-steering techniqe for phased-array antennas'**
• **APPLIED OPTICS, Bd.31, Nr.35, Dezember 1992, NEW YORK US Seiten 7395 - 7397 R. SOREF 'Optical dispersion technique for time-delay beam steering'**

**Beschreibung**

Die Erfindung betrifft eine Signalverteilungsanordnung, mit der ein zentral erzeugtes Signal auf mehrere Signalempfänger verteilt wird. Ein Anwendungsbeispiel sind z.B. elektromagnetische Mehrelementantennen, bei denen ein von einer Quelle zentral erzeugtes Signal auf die Sende- und Empfangsmodule der Antenne verteilt wird, wie z.B. aus der US-A-4 885 589 bekannt.

Beim Übertragen von Signalen unterscheidet sich die Phase am Ende der Übertragungsstrecke von der des eingespeisten Signals abhängig von Signalfrequenz und Signallaufzeit. Letztere ist während des Betriebes äußeren Einflüssen unterworfen, was sich bei hohen Signalfrequenzen und/oder langen Signalwegen beispielsweise aufgrund der Änderung der thermischen Umgebung in unzulässig hohen Phasenfehlern bemerkbar machen kann. Signale können zum Beispiel elektrischer, elektromagnetischer, akustischer oder anderer Wellennatur sein, die in geeigneten Medien - hier Leitungen genannt - geführt werden. Einflüsse auf die Signalgeschwindigkeit im Leiter können beispielsweise die Umgebungstemperatur, -druck, mechanische Verformungen, Zug-, Druck-, Scher- und Biegespannungen, elektrische und magnetische Felder, akustische Wellen oder Strahlung verschiedenen Ursprungs sein.

Um störende Schwankungen in der Ausbreitungsdauer entlang der Leitungen in den verschiedenen Kanälen eines Netzwerks zu unterdrücken, werden gegenwärtig grundsätzlich zwei verschiedene Lösungsansätze verfolgt. Zum einen wird versucht, das Netzwerk gegenüber den Störeinflüssen abzuschirmen, bzw. durch spezielle Ummantelungen diesen Einfluß zu senken, was oft einen erheblichen (im allgemeinen mechanischen) Zusatzaufwand bedeutet. Ein anderer Ansatz liegt darin, individuell für jede Leitung das Signal so zu verzögern, daß es nach der Übertragung die nominale Gesamtverzögetung durchlief. Bei elektromagnetischen Mehrelementantennen, wie etwa satellitengetragenen großflächigen SAR-Antennen, wird dies oft durch Phasensteller realisiert. Dafür wird die tatsächliche Signallaufzeit in den Leitungen benötigt, die in Kalibrationszyklen für jede Leitung gemessen werden muß. Beispielsweise soll über X-Band Antennen die Laufzeit auf besser als 1 ps stabil sein, was einer Ausbreitungsstrecke im Vakuum von 0,3 mm entspricht.

Aufgabe der Erfindung ist es, ein Signalverteilungsnetzwerk zu schaffen, bei dem äußere Störeinflüsse mit möglichst wenig Aufwand (ohne Kalibrationszyklen oder Abschirmung) kompensiert werden können.

Diese Aufgabe wird durch eine Signalverteilungsanordnung nach Patentanspruch 1 gelöst. Vorteilhafte Ausbildungen der Erfindung sind Gegenstand von Unteransprüchen.

Mit der Erfindung gelingt es, ein Netzwerk zur Verteilung eines zentral erzeugten Signals auf mehrere Signalempfänger zu schaffen, welches für jedes Wegelement eine bei der Auslegung wählbare Empfindlichkeit der Ausbreitungsdauer auf die umgebenden Einflüsse zeigt. Dieser - vom Ort x (bzw. Ort s) abhängige - Einfluß wird T(x) genannt. Man kann sich darunter die Temperaturverteilung entlang der Leitung vorstellen. Die Koordinate x bezeichnet den Ort entlang des Wegs auf dem die Leitungen geführt werden. Wesentlich für die Erfindung ist die Erkenntnis, daß der Einfluß einer T(x)-Schwankung nicht unterdrückt oder im Vorzeichen ausgewählt werden kann. Im Verhalten der Leitungen relativ zueinander kann das aber erreicht werden. Erfindungsgemäß umfaßt die Vorrichtung folgende Merkmale:

- die Leitungen sind entlang eines gemeinsamen Weges x geführt, entlang dessen Abzweige für die einzelnen Signalempfänger vorliegen. Dadurch wird erreicht, daß die Leitungen den gleichen Störungen ausgesetzt sind;
- für die einzelnen Leitungen gilt: die Leitung für den i-ten Signalempfänger (der Index i ist die laufende Nr. der Signalempfänger entlang des gemeinsamen Wegs) ist von der Signalquelle bis zu dem Abzweig für den i-ten Signalempfänger entlang des gemeinsamen Wegs ungeradzahlig oft verlegt und vom Abzweig des i-ten Signalempfängers bis zum Ende des gemeinsamen Wegs geradzahlig oft verlegt;
- die einzelnen Leitungen sind in mindestens zwei Abschnitte aufgeteilt, in der sie unterschiedliche relative Empfindlichkeiten aufweisen
- innerhalb jedes Wegelements Δx entlang des gemeinsamen Wegs gilt: Anzahl der Verlegungen einer Leitung * relative Empfindlichkeit E der Leitung = konstant für alle Leitungen.

Zur Definition der relativen Empfindlichkeit E:
Die Gesamtlaufzeit t eines Signals durch eine Leitung entlang eines Weges ergibt sich bei der Ausbreitungsgeschwindigkeit c(T(s)) zu:

$$t = \int_{Anfang}^{Ende} \frac{1}{c(T(s))} ds = \int_{Anfang}^{Ende} \frac{p \cdot s'(x)}{c_0(T(x))} dx$$

mit

$$s' := \frac{\partial s}{\partial x}$$

und $c_o(T(x)) =$      Ausbreitungsgeschwindigkeit des Signals in einer Standardleitung - abhängig vom äußeren Einfluß $T(x)$ an der Stelle $x$

und $p =$      beispielsweise durch Dotierung geänderte Abhängigkeit der Ausbreitungsgeschwindigkeit gegenüber der für $c_o(T(x))$ gewählten Standardleitung, so daß:

$$p = \frac{c_o(T)}{c(T)}$$

für alle Störungen T, die relevant sind.
Gewöhnlich genügt differentiell:

$$p = \frac{\dfrac{\partial c_o(T)}{\partial T}}{\dfrac{\partial c(T)}{\partial T}}$$

Das Produkt $s'*p$ wird im folgenden als relative Empfindlichkeit E oder auch relative Ausbreitungsempfindlichkeit bezeichnet. Das Wegelement ds wird entlang der Leitung gemessen, während die Koordinate x entlang des gemeinsamen Weges, also dem Verlauf des Leitungsbündels, in dem die Leitungen zusammengefaßt sind, interpretiert wird. Die relative Empfindlichkeit E kann somit durch zwei Maßnahmen eingestellt werden:

1. Das Verhältnis von Leitungslängenelement ds zu Weglängenelement dx läßt sich bei ausreichender Gestaltungsfreiheit des Leitungsweges einstellen. Setzt man ein ausreichend "geraden" Weg entlang x für das Leitungsbündel an, so lassen sich durch Schlaufenlegen und Umwickeln mit der Leitung Werte für ds/dx größer gleich 1 einstellen. Ein gleichmäßiges ds/dx über den Weg x läßt sich durch Verlegen der Leitung entlang einer Schraubenlinie einstellen. Über die Steigung der Schraubenlinie läßt sich das Verhältnis ds/dx einstellen. Die Drehrichtung der Schraubenlinie entlang des Weges umzudrehen kann Vorteile bringen, wenn Störeinflüsse unterdrückt werden sollen (z.B. bei elektromagnetischer Einstrahlung).

2. Die relative Empfindlichkeit E kann neben der erwähnten Möglichkeiten der speziellen räumlichen Verlegung aber auch durch Wahl des Leitungsmaterials oder durch eine geeignete Dotierung eingestellt werden (Variation von p), wodurch die Anzahl der Wellenzüge pro Längeneinheit verändert wird.

Anwendungen der Erfindungen liegen insbesonde bei Bündeln von Leitungen, die zu verschiedenen Orten verlegt werden, die relativ zueinander auf variierende $T(x)$ ihre Ausbreitungsdauer möglichst gering nur ändern. Bei thermisch extremen Schwankungen ausgesetzten SAR-Antennen ist damit ein Netzwerk möglich, welches Phasen- oder Laufzeitschwankungen der einzelnen Kanäle relativ zueinander unterdrückt, ohne daß das Netzwerk besonders abgeschirmt oder immer wieder vermessen werden müßte. Datüberhinaus kann die erfindungsgemäße Vorrichtung zur Verteilung von Signalen bei hohen Trägerfrequenzen, z.B. optischen Frequenzen angewandt werden, bei denen die absolute Empfindlichkeit gegenüber den äußeren Störungen drastisch reduziert wird.

Ob die Leitungen wieder zentral zusammengeführt werden oder in welcher Richtung das Netzwerk betrieben wird, ist dabei nicht von Belang. Insbesondere kann die erfindungsgemäße Anordnung neben dem Verteilen auch zum Sammeln von Signalen verwendet werden. Das entspricht dem Empfangsfall bei einer Mehrelementenantenne. Dabei wird die zentrale Signalquelle durch einen zentralen Empfänger ersetzt und die Signalempfänger werden durch Vorrichtungen zur Signaleinspeisung ersetzt.

Für Leitungsbündel gilt, daß der Einfluß $T(x)$ sich über den Bündelquerschnitt an beliebigen Orten entlang des Bündels nur gering ändert. Die Qualität dieser Gleichförmigkeit hängt vom Durchmesser, der Matrix, in die die Leitungen eingebettet sind, und der räumlichen Variation des Einflusses T ab. Beispielsweise eignen sich wärmeleitende Stoffe als Einbettung und eine wärmeisolierende Schicht als Umhüllung gut, um Thermalgradienten zu reduzieren.

Die Erfindung wird anhand von Zeichnungen näher beschrieben.
Es zeigen:

Fig. 1      eine schematische Darstellung der erfindungsgemäßen Vorrichtung, in der mehrere Beispiele zum Aspekt der Mehrfachverlegung der Leitungen gezeigt sind;

Fig. 2 den Verlauf zweier einzelner Leitungen mit bestimmten Werten für die relative Empfindlichkeit;

Fig. 3 eine Ausführungsform der erfindungsgemäßen Vorrichtung.

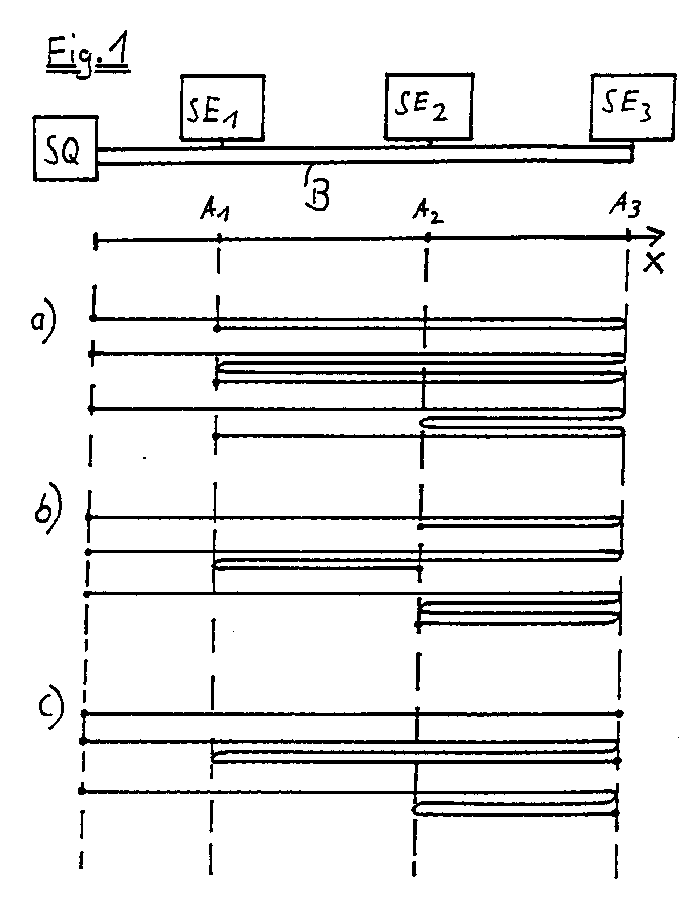

Fig. 1 zeigt in schematischer Darstellung mehrere mögliche Ausführungsformen der Signalverteilungsanordnung. Ganz oben ist eine Signalquelle SQ abgebildet, deren Signal über einzelne Leitungen, die zu einem Bündel B zusammengefaßt sind, an mehrere Signalempfänger $SE_i$ verteilt wird. Jeder Signalempfänger $SE_i$ ist über jeweils eine Leitung mit der Quelle verbunden.

Bei der gezeigten Anordnung kann es sich z.B. um eine aktive Antenne handeln, bei der ein von der Signalquelle zentral erzeugtes Signal an die T/R (Transmit/Receive)-Module verteilt wird, wobei die Leitungen als Glasfasern ausgebildet sind.

Die einzelnen Leitungen sind entlang eines gemeinsamen Weges geführt. Das bedeutet, daß sämtliche Leitungen in jedem Wegelement entlang dieses gemeinsamen Weges zumindest einfach verlegt sind. Dieser gemeinsame Weg entspricht hier dem Verlauf des Leitungsbündels B von der Quelle SQ bis zum letzten Signalempfänger $SE_3$. Die Koordinate x des gemeinsamen Weges ist anhand einer Koordinatenachse eingezeichnet. Entlang dieser Achse sind die Positionen der Abzweige $A_i$ für die Signalempfänger $SE_i$ markiert. An diesen Punkten wird die entsprechende Leitung aus dem Bündel heraus und an den entsprechenden Signalempfänger geführt. Der Verlauf des gemeinsamen Wegs ist in diesem Ausführungsbeispiel geradlinig ausgebildet. Es sind aber auch andere Verläufe, z.B. gekrümmt, stern- oder kreisförmig möglich.

In den Fig. 1a), 1b), 1c) (unten) sind Beispiele dargestellt, wie die Leitungen innerhalb des Bündels B im einzelnen verlegt sein können.

Fig. a) zeigt drei verschiedene Möglichkeiten für die Leitung, die mit dem ersten Signalempfänger $SE_1$ verbunden ist. Beim ersten Beispiel (oben) wird die Leitung von der Quelle über den Abzweig $A_1$ des Signalempfängers $SE_1$ hinweg bis zum Abzweig $A_3$ des dritten Signalempfängers $SE_3$ geführt und von dort zurück zum Abzweig $A_1$. Erst jetzt erfolgt der Anschluß an den Signalempfänger $SE_1$. In diesem Beispiel ist die Leitung somit zwischen Quelle SQ und Abzweig $A_1$ zum ersten Signalempfänger $SE_1$ einfach, im übrigen Bereich des gemeinsamen Wegs doppelt verlegt. Beim zweiten Beispiel in Fig. 1a) wird die Leitung ebenfalls bis zum Ende des gemeinsamen Wegs am Abzweig $A_3$ des dritten T/R-Moduls geführt, von dort zurück zum zweiten Signalempfängers $SE_2$, wieder zurück zum Abzweig $A_3$ des dritten Signalempfängers $SE_3$ und dann erst zur Einspeisung an den Abzweig des Signalempfängers $SE_1$. In diesem Beispiel ist die Leitung somit im Bereich zwischen Quelle SQ und Abzweig $A_1$ des ersten Signalempfängers $SE_1$ einfach (ungeradzahlig oft) verlegt, im Bereich zwischen ersten $A_1$ und zweiten Abzweig $A_2$ doppelt verlegt (geradzahlig oft) und im Bereich zwischen $A_2$ und $A_3$ vierfach verlegt.

Beim dritten Beispiel in Fig. 1a) schließlich wird die Leitung zwischen $A_1$ und $A_2$ zweifach verlegt, und zwischen $A_2$ und $A_3$ vierfach verlegt.

Fig. 1b) und 1c) zeigen in analoger Darstellung jeweils drei Möglichkeiten für die Verlegung der Leitung zur Versorgung des zweiten Signalempfängers $SE_2$ (Fig. b) und des dritten Signalempfängers $SE_3$.

Bei allen Beispielen gilt, daß die Leitung zur Versorgung des i-ten Signalempfängers $SE_i$ im Bereich des gemeinsamen Wegs von der Quelle bis zum i-ten Abzweig $A_i$ ungeradzahlig oft verlegt ist, und vom i-ten Abzweig bis zum Ende des gemeinsamen Wegs geradzahlig oft verlegt ist.

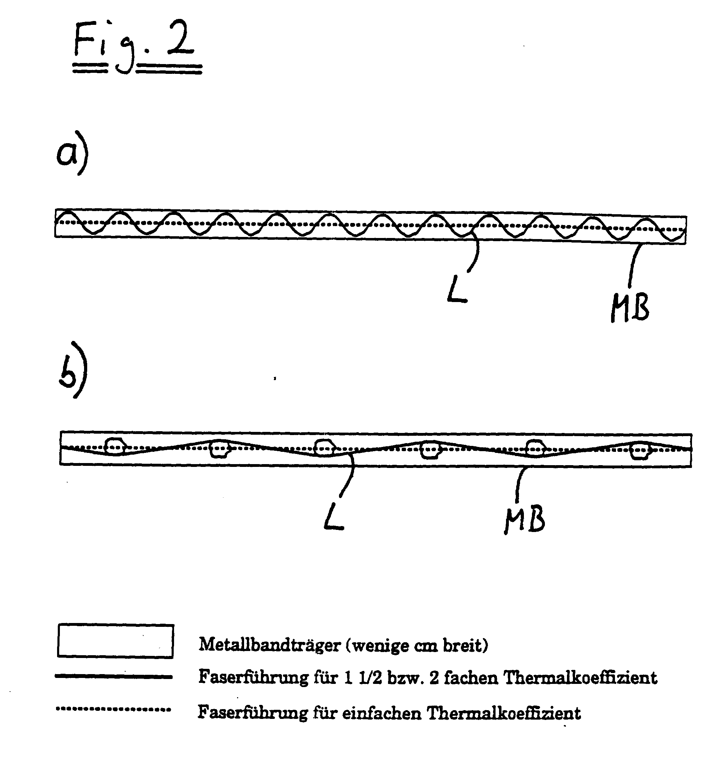

Die Darstellung zeigt nur den Aspekt der Mehrfachverlegung der Leitungen entlang einzelner Abschnitte des gemeinsamen Wegs. Nicht dargestellt ist die weitere Maßnahme, die Leitungen in einzelne Abschnitte von unterschiedlicher relativer Empfindlichkeit zu unterteilen. Dies kann, wie oben erwähnt, durch geeignete Materialwahl oder durch Einstellung des Quotienten ds/dx erreicht werden. Im letzteren Fall verlaufen die Leitungen innerhalb des Bündels B nicht geradlinig, wie in Fig. 1 dargestellt, sondern auf Spiralen, Bogenlinien oder anderen geeigneten zwei- oder dreidimensionalen Wegen. Zwei Ausbildungen hierzu werden in der Fig. 2 beschrieben.

Fig. 2 zeigt zwei geometrische flache Lösungen für das Problem, Leitungen, insbesondere Glasfasern entlang eines Weges mit einem quantitativ eineinhalbfachen (Fig. a) oder doppelten (Fig. b) Empfindlichkeit auf Temperaturänderungen zu verlegen. Um thermische Gradienten quer und längs des Weges aufgrund äußerer Wärmestrahlung zu vermindern, werden die Leitungen auf einem guten Wärmeleiter, hier einem Metallbandträger MB montiert, der typischerweise eine Breite von wenigen cm aufweist.

In Fig. 2a) wird die Leitung L in Form einer Wellenlinie verlegt. Die eingezeichnete Leitung hat einen Quotienten ds/dx = 1,5 . Die Koordinate s wird dabei entlang der Leitung L gemessen. Die Koordinate x wird entlang der gestrichelten Linie gemessen, die hier geradlinig verläuft. Sie entspricht dem Verlauf des gemeinsamen Weg bzw. dem Leitungsbündel B nach Fig. 1, in dem mehrere Leitungen zusammengefaßt sind. Bei dem angegebenen Wert für ds/dx handelt es sich um einen Durchschnittswert gemittelt über eine grösseres Längenelement $\Delta x$. Da bei vielen Anwendungen die Störungen entlang des Weges relativ langsam (räumlich gesehen) sich verändern, ist dort nur dieser Mittelwert relevant. In Fig. 2b werden in regelmäßigen Abständen zusätzlich kleine Schlaufen gelegt. Diese Leitung weist einen Wert für ds/dx = 2 auf.

Die in den Fig. a) und b) dargestellten Ausführungsformen wie auch eine dreidimensionale Schraubenlinie sind unempfindlich gegenüber beliebigen gleichförmigen örtlichen Temperaturgradienten (in allen Richtungen der Ebene). Gradienten höherer Ordnung können durch eine einfache Isolation gegenüber der Umgebung ausreichend unterdrückt werden. Diese Unempfindlichkeit gilt für alle symmetrisch ausgelegten Anordnungen.

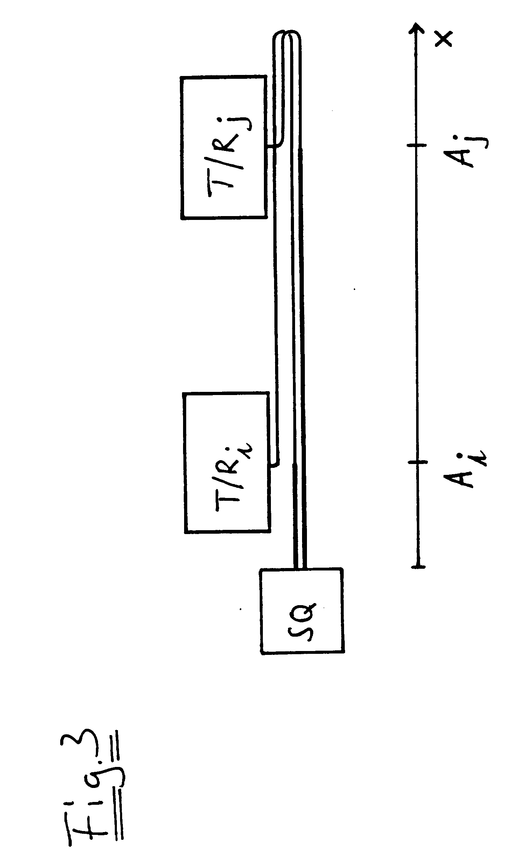

Eine vorteilhafte Ausführungsform der erfindungsgemäßen Signalverteilungsanordnung zeigt Fig. 3. Abgebildet sind zwei T/R-Module $T/R_i$, $T/R_j$ einer aktiven Antenne, die über glasfaseroptische Leitungen mit einem zentral erzeugten Signal versorgt werden. Eine derartige aktive Antenne enthält in der Regel eine größere Anzahl von T/R-Modulen (>100). Die in der Fig. 3 gezeigten sind davon als repräsentative Module mit den zugehörigen Zuleitungen herausgegriffen. Die beiden dargestellten Module müssen nicht direkt benachbart sein. Zwischen den beiden Modulen sowie vor Modul $T/R_i$ und nach Modul $T/R_j$ können eine beliebige Anzahl weiterer Module angeordnet sein.

Zweck der gezeigten Anordnung ist die Kompensation thermischer Einflüsse auf die Abstrahlqualität der Antenne. Durch Unterdrückung differentieller (zwischen den Modulen) Laufzeitschwankungen soll erreicht werden, daß die Phasenbelegung der Antenne und damit deren Fernfeld nicht unzulässig verändert wird.

Das Signal wird an der Signalquelle SQ in die Leitungen eingespeist und an die verschiedenen Module verteilt. Die Leitungen aller Module werden entlang desselben Weges verlegt, damit alle Leitungen den gleichen äußeren Störungen ausgesetzt sind. Die Koordinatenachsen für den gemeinsamen Weg (Koordinate x) des gemeinsamen Wegs ist ebenfalls eingezeichnet. Entlang des gemeinsamen Wegs befinden sich die Abzweige für die einzelnen Module. Die Position dieser Abzweige sind auf der x-Koordinatenachse eingezeichnet. Die parallel verlaufenden Leitungen werden möglichst nahe aneinandergebracht oder gegenseitig umwickelt und zu einem Bündel zusammengefaßt. Aus Gründen der Klarheit sind sie hier mit einem endlichen Abstand voneinander eingezeichnet.

Die Leitung zu Modul $T/R_i$ wird entlang des gemeinsamen Wegs über den Abzweig $A_i$ hinaus bis zum Ende des gemeinsamen Wegs geführt und anschließend zu $A_i$ und in das Modul $T/R_i$ zurückgeführt. Die Leitung zu Modul $T/R_j$ wird ebenfalls entlang des gesamten gemeinsamen Wegs geführt, und danach zu $A_j$ und dem zugehörigen Modul $T/R_j$ zurückgeführt.

Jede Leitung von der Einspeisung des Licht an der Signalquelle bis zum Anschluß an das T/R-Modul kann in zwei Abschnitte aufgeteilt werden. Der erste Abschnitt, der dick eingezeichnet ist und im folgenden Typ U genannt wird, ist eine ungerade Anzahl entlang des gemeinsamen Wegs geführt (hier einmal). Dieser Abschnitt dient dem Transport des Signals von einem Ende zum anderen. Der andere Abschnitt, dünn eingezeichnet und im folgenden Typ G genannt, ist eine gerade Anzahl von Malen entlang des gemeinsamen Wegs geführt (hier: zweimal, d.h. eine Schleife). Um diesen Abschnitt wird die Leitung erweitert, um gleiche Signallaufzeit und gleiche Phasenänderungen bei äußeren Störungen entlang beliebiger Wegelemente $\Delta x$ in allen Leitungen zu erreichen. Bei dieser Schlaufe liegen Eingang und Ausgang der Leitung dicht nebeneinander.

Damit die Gesamtempfindlichkeit der Leitungen auf äußere Störungen untereinander gleich ist, weisen die Leitungen in den der Abschnitten vom Typ U und Typ G einem bestimmten Wert $E_U = s'_U * p_U$ bzw. $E_G = s'_G * p_G$ für die relative Empfindlichkeit auf. In dem abgebildeten Beispiel sind die dick eingezeichnet Leitungsabschnitte vom Typ U geradlinig verlegt ($s'_U = 1$) und bestehen aus einem Material mit einem bestimmten $p_U$, die dünn eingezeichneten Leitungsabschnitte vom Typ G sind ebenfalls gerade verlegt ($s'_G = 1$), sie bestehen jedoch aus einem Material mit einem anderen $p_G$.

Für den allgemeinen Fall gilt, daß innerhalb eines Wegelements $\Delta x$ entlang des gemeinsamen Wegs eine Leitung (2n+1)-fach (Typ U) mit der relativen Empfindlichkeit $E_U$ verlegt ist, und die andere Leitung im selben Wegelement 2m-fach (Typ G) mit der relativen Empfindlichkeit EG verlegt ist :

$$(2n+1)*E_U = 2m * E_G.$$

Die relative Empfindlichkeit $E_U$, $E_G$ kann dabei durch eine entsprechende Wahl der Leitermaterialien (Variation von $p_G$ bzw. $p_U$) oder durch die Einstellung eines bestimmten $s' = ds/dx$ erreicht werden, letzteres z.B. entsprechend der in Fig. 2 gezeigten Beispiele. Wie bereits oben erwähnt, ist das $\Delta x$, innerhalb der die obige Gleichung gilt, abhängig von der Größe der räumlichen Änderung der äußeren Störung. Oft schwanken die Störungen räumlich gesehen "langsam genug", so daß $E_U$, $E_G$ in obiger Gleichung gemittelte Werte über $\Delta x$ darstellen.

Bevorzugt werden folgende Werte entlang eines Wegelements $\Delta x$, z.B. zwischen $A_i$ und $A_j$ verwendet:

- Dreifaches Verlegen (n=1) mit $s'_U = ds/dx = 1$, d.h. geradliniges Verlegen ohne Windungen o.ä.

$$(2n+1)*s'_U = 3*1 = 3$$

- Doppeltes Verlegen (m=1) mit $s'_G = ds/dx = 1{,}5$ (z.B. in Form einer Schraubenlinie)

$$2m*s'_G=2*1,5=3$$

Somit ist die Gesamtempfindlichkeit innerhalb des Wegelements für beide Leitungen gleich groß.

In weiteren Ausführungen (hier nicht dargestellt), in denen der Abstand vom Abzweig $A_i$ zum T/R-Modul i so groß ist, daß er für die Kompensation äußerer Störungen nicht mehr zu vernachlässigen ist, können zusätzlich sämtliche Leitungen entlang eines gemeinsamen Wegs vom Abzweig $A_i$ bis zum T/R-Modul i geführt werden. Dabei würde die Leitung für das i-te Modul ungeradzahlig oft (2n+1 mal) , alle übrigen Leitung geradzahlig oft (2m mal = m Schlaufen) entlang dieses Weges geführt. Um Strahlschwenkungen durch differentielle Phasenfehler zu vermeiden, genügt es jedoch, wenn die Schlaufen zu den Modulen lediglich paarweise bei symmetrisch zur Mitte liegenden Modulen und nicht zu jedem Modul führen.

## Patentansprüche

1. Signalverteilungsanordnung, umfassend eine zentrale Signalquelle (SQ), mehrere Signalempfänger ($SE_i$ ) sowie jeweils einer Leitung vom den Signalquelle (SQ) zu den einzelnen Signalempfängern ($SE_i$), **dadurch gekennzeichnet**, daß

   - die Leitungen entlang eines gemeinsamen Weges (x) geführt sind, entlang dessen Abzweige ($A_i$) für die einzelnen Signalempfänger ($SE_i$) vorliegen, wobei die Leitung für den i-ten Signalempfänger entlang des gemeinsamen Wegs von der Signalquelle (SQ) bis zu dem Abzweig ($A_i$ ) für den i-ten Signalempfänger ($SE_i$) ungeradzahlig oft verlegt ist und von diesem Abzweig ($A_i$) bis zum Ende des gemeinsamen Wegs geradzahlig oft verlegt ist, und
   - die Leitungen in mindestens zwei Abschnitte aufgeteilt sind, die unterschiedliche relative Empfindlichkeiten aufweisen und
   - für die Leitungen in den Wegelementen ($\Delta x$) entlang des gemeinsamen Wegs (x) gilt:
   Anzahl der Verlegungen der Leitung * relative Empfindlichkeit der Leitung = konstant.

2. Signalverteilungsanordnung nach Anspruch 1, **dadurch gekennzeichnet**, daß die relative Empfindlichkeit über den Quotienten ds/dx $\geq$ 1 eingestellt wird, mit x= Koordinate entlang des gemeinsamen Wegs, s = Koordinate entlang der Leitung.

3. Signalverteilungsanordnung nach Anspruch 2, **dadurch gekennzeichnet**, daß der Quotient ds/dx durch Führen der Leitung in Form einer Schraubenlinie definierter Steigung eingestellt wird.

4. Signalverteilungsanordnung nach Anspruch 1, **dadurch gekennzeichnet**, daß die relative Empfindlichkeit durch geeignete Materialwahl oder Dotierung eingestellt ist.

5. Signalverteilungsanordnung nach einem der vorangehenden Ansprüche, **dadurch gekennzeichnet**, daß die Leitungen miteinander verdrillt sind.

6. Signalverteilungsanordnung nach einem der vorangehenden Ansprüche, **dadurch gekennzeichnet**, daß die Leitungen in einer gemeinsamen Matrix eingebettet sind, die die äußeren Störungen gleichmäßig über den Querschnitt aller Leitungen leitet, womit Störungsgradienten unterdrückt werden.

7. Signalverteilungsanordnung nach einem der vorangehenden Ansprüche, **dadurch gekennzeichnet**, daß das Leitungsbündel gegen äußere Störungsgradienten isoliert ist.

8. Signalverteilungsanordnung nach einem der vorangehenden Ansprüche, **dadurch gekennzeichnet**, daß sie nicht zum Verteilen vom Signalen, sondern zum Sammeln von Signalen verwendet wird, wobei die zentrale Signalquelle durch einen zentralen Empfänger ersetzt ist und die Signalempfänger durch Vorrichtungen zur Signaleinspeisung ersetzt sind.

## Claims

1. Signal distribution arrangement, comprising a central signal source (SQ), several signal receivers ($SE_1$) and also

respective lines from the signal source (SQ) to the individual signal receivers (SE$_1$), **characterised in that**

- the lines are guided along a common path (x), along which there are feeders (A$_1$) for the individual signal receivers (SE$_1$), the line for the i-th signal receiver being laid an odd number of times along the common path from the signal source (SQ) to the feeder (A$_i$) for the i-th signal receiver (SE$_1$) and being laid an even number of times from that feeder (A$_1$) to the end of the common path, and
- the lines are divided into at least two sections which have different relative sensitivities and
- the following applies to the lines in the path increments ($\Delta$x) along the common path (x); the number of runs of the line * relative sensitivity of the line = constant.

2. Signal distribution arrangement according to claim 1, characterised in that the relative sensitivity is adjusted by way of the quotient ds/dx $\geq$ 1, with x = coordinate along the common path, s = coordinate along the line.

3. Signal distribution arrangement according to claim 2, characterised in that the quotient ds/dx is adjusted by guiding the line in the form of a helix of defined pitch.

4. Signal distribution arrangement according to claim 1, characterised in that the relative sensitivity is adjusted by suitable choice of material or by doping.

5. Signal distribution arrangement according to any one of the preceding claims, characterised in that the lines are twisted with one another.

6. Signal distribution arrangement according to any one of the preceding claims, characterised in that the lines are embedded in a common matrix which passes the external influences uniformly over the cross-section of all lines, thus suppressing interference gradients.

7. Signal distribution arrangement according to any one of the preceding claims, characterised in that the line bundle is isolated against external interference gradients.

8. Signal distribution arrangement according to any one of the preceding claims, characterised in that it is used not to distribute signals but to gather signals, the central signal source being replaced by a central receiver and the signal receivers being replaced by devices for feeding in signals.

**Revendications**

1. Dispositif de distribution de signaux, comprenant une source de signaux centrale (SQ), plusieurs récepteurs de signaux (Se$_i$) ainsi que des lignes conduisant respectivement de la source de signaux (SQ) aux différents récepteurs de signaux (Se$_i$), **caractérisé en ce**

- que les lignes s'étendent le long d'un chemin commun (x) le long duquel sont prévus des embranchements (A$_i$) pour les différents récepteurs de signaux (Se$_i$), la ligne pour le i-ième récepteur de signaux est repliée un nombre impair de fois le long du chemin commun entre la source de signaux (SQ) et l'embranchement (A$_i$) pour le i-ième récepteur de signaux (Se$_i$), et entre ledit embranchement (A$_i$) et la fin du chemin commun, un nombre pair de fois,
- que les lignes sont divisées au moins en deux sections présentant des sensibilités relatives différentes,
- que pour les lignes dans les éléments de chemin ($\Delta$x) le long du chemin commun (x), on a : Nombre de replis de la ligne * sensibilité relative de la ligne = constant.

2. Dispositif de distribution de signaux selon la revendication 1, caractérisé en ce que la sensibilité relative est réglée par l'intermédiaire du quotient ds/dx $\geq$ 1, avec x = coordonnée le long du chemin commun, s = coordonnée le long de la ligne.

3. Dispositif de distribution de signaux selon la revendication 2, caractérisé en ce que le quotient ds/dx est réglé par le guidage de la ligne sous la forme d'une ligne hélicoïdale de pas défini.

4. Dispositif de distribution de signaux selon la revendication 1, caractérisé en ce que la sensibilité relative est réglée par le choix du matériau adéquat ou par dopage.

**5.** Dispositif de distribution de signaux selon l'une des revendications précédentes, caractérisé en ce que les lignes sont torsadées les unes avec les autres.

**6.** Dispositif de distribution de signaux selon l'une des revendications précédentes, caractérisé en ce que les lignes sont encastrées dans une matrice commune qui transmet les perturbations extérieures uniformément sur la section transversale de toutes les lignes, ce qui a pour effet de supprimer des gradients de perturbation.

**7.** Dispositif de distribution de signaux selon l'une des revendications précédentes, caractérisé en ce que le faisceau de lignes est isolé par rapport à des gradients de perturbation extérieurs.

**8.** Dispositif de distribution de signaux selon l'une des revendications précédentes, caractérisé en ce qu'il est utilisé non pas pour la distribution de signaux mais pour la collecte de signaux, la source de signaux centrale étant remplacée par un récepteur central, et les récepteurs de signaux étant remplacés par des dispositifs d'injection de signaux.

Fig.1

Fig. 2

a)

L

MB

b)

L

MB

Metallbandträger (wenige cm breit)

Faserführung für 1 1/2 bzw. 2 fachen Thermalkoeffizient

Faserführung für einfachen Thermalkoeffizient

Fig. 3